# EUROPEAN PATENT SPECIFICATION

(11) **EP 0 476 719 B1**
(45) Date of publication and mention of the grant of the patent: **26.04.1995**
(21) Application number: 91119581.6
(22) Date of filing: 02.08.1988
(51) Int. Cl.: G06K 15/12, H01S 3/133

(54) **A control circuit for a laser printer**
Steuerschaltung für Laserdrucker
Circuit de commande pour imprimante à laser

(30) Priority: 25.08.1987 NL 8701986
(43) Date of publication of application: 25.03.1992
(62) Divisional of application: 88201657.9
(73) Proprietor: Océ-Nederland B.V., 5914 CC Venlo (NL)
(72) Inventor: Joosten, Louis Gerardus Josephus, NL-5988 AP Helden (NL); Stemkens, Matheas Theodorus Maria, NL-5991 CL Baarlo (NL)
(74) Representative: Hanneman, Henri W., Dr.

(56) References cited:
- US-A- 4 612 555
- TECHNISCHES MESSEN vol. 50, no. 2, February 1983, MUENCHEN, DE pages 49 - 54 W.S. LUDOLF 'Grundlagen der optischen Uebertragungstechnik - Eine Einfuehrung fuer Anwender'
- PATENT ABSTRACTS OF JAPAN vol. 6, no. 72 (E-105)(950) 7 May 1982

## Description

This invention relates to a control circuit for a laser printer.

A control circuit of this kind is known from US Patent 4 612 555.
The laser printer described therein comprises a switching amplifier for controlling a laser diode, a variable current source being used as a common emitter resistor for two switching transistors. A second current source is described for adjusting the base current through the laser diode. A photodiode is also provided which measures the emitted amount of light and the energization current through the laser diode is determined on the basis of this measurement.

It is a property of a laser diode that when current is supplied it takes some time before the laser diode emits light. This is a particularly troublesome property if the laser diode is used in a high speed and/or high resolution laser printer. On the basis of a switch-on delay time of about 6 nsec and a writing frequency of about 10 MHz, the switch-on point of the laser lies approximately 6 »m later than expected. A broadening of this kind, for example, with respect to fonts with a resolution of 20 image dots per mm, is visually disturbing. A further disadvantage is that there is a difference between the leading and trailing flanks of the input pulses for the laser circuit, resulting in non exact length of the information written.

The object of the invention is to provide a control circuit in which this and other disadvantages are obviated. According to the invention this object is attained in a control circuit according to the preamble by the measures of the characterising part of claim 1.

Consequently, input pulse for the laser circuit is symmetrical and the line written by the laser printer corresponds exactly to the image information supplied.

These and other advantages will be explained in the following description with reference to the accompanying drawings wherein:
Fig. 1 is a diagram of a control circuit for a laser printer,
Fig. 2 is a diagram of a laser switching amplifier according to the invention,
Fig. 3 is a diagram of a correction circuit,
Fig. 4 illustrates the signal forms which occur in this correction circuit,
Fig. 5 is a diagram of a protective circuit,
Fig. 6 is a diagram of a voltage-to-current converter,
Fig. 7 is a diagram of a light intensity-to-voltage converter,
Fig. 8 is a diagram of a sample-and-hold circuit,
Fig. 9 is a diagram of a differential amplifier, and
Fig. 10 is a diagram of a regulating circuit.

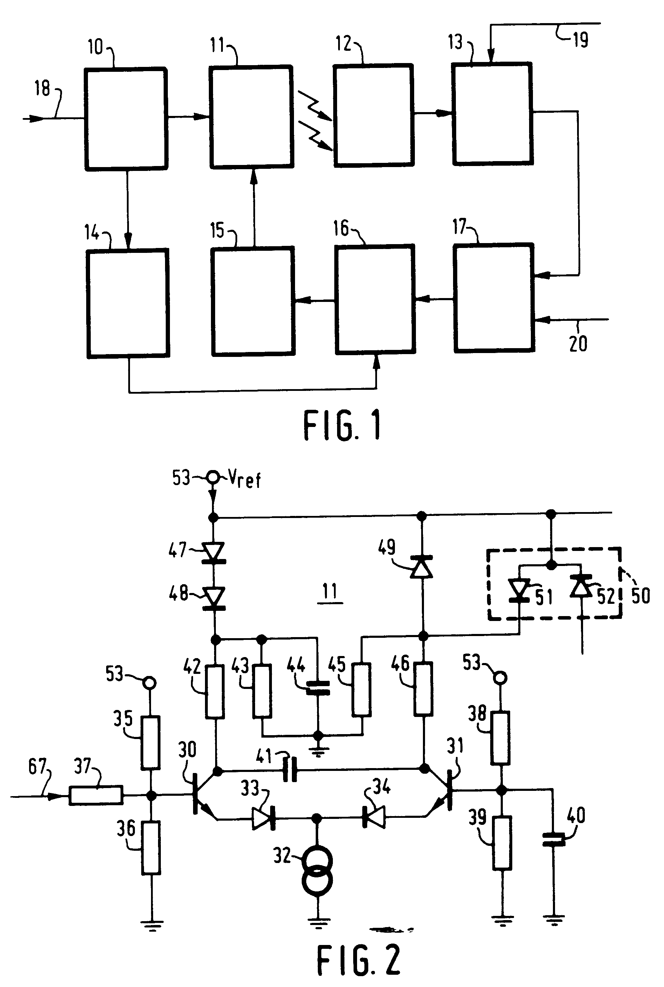

Fig. 1 is a diagram of a control circuit for a laser printer in which a laser diode is modulated by means of image or video signals. The modulated laser beam is deflected linewise over a photosensitive medium by means of a polygonal mirror. The laser diode is driven by a laser switching amplifier 11. The laser diode is disposed in an envelope which also contains a photodiode which delivers a signal related to the amount of light emitted by the laser diode. The related signal is converted into a voltage by a light intensity-to-voltage converter 12. This voltage is fed to a sample-and-hold circuit 13. After an image line has been written, a sample signal is fed via a line 19 to the sample-and-hold circuit 13. The voltage which was present at the time of sampling is retained until the next sampling signal. During this time the laser is on. This voltage is fed to a differential amplifier 17 and is compared with a reference signal fed via line 20. This reference signal represents the required light output of the laser diode. In the event of inequality of the two signals a differential signal is generated and is fed to a regulating circuit 16. Regulating circuit 16 delivers a d.c. voltage which is fed to a voltage-to-current converter 15. The current generated here acts as switching current for the laser diode. If the laser diode output is too low, the current will increase via circuits 12, 13, 17, 16 and 15 so that the light output increases, and so on.

The regulating system described corrects the light output on each image line while the response time of the regulating circuit is equivalent to a number of image lines.

The image signal is fed via line 18 to a correction circuit 10. As will be described hereinafter, this circuit 10 compensates for the delayed light emission of the laser diode. The corrected image signal is fed as a modulation signal to the laser switching amplifier 11.

The image signal is also fed (via correction circuit 10) to a protective circuit 14, and the output of the latter is connected to the regulating circuit 16.

Fig. 2 illustrates the laser switching amplifier diagrammatically. The heart of the circuit is formed by a differential amplifier having a common current source 32 in the emitter leads of transistors 30 and 31. The right-hand chain of the differential amplifier is formed by transistor 31, resistors 45 and 46, and laser diode 51. The left-hand chain of the differential amplifier is formed by transistor 30, resistors 42 and 43, capacitor 44, and diodes 47 and 48. The base of transistor 31 is at a fixed potential via a voltage divider formed by resistors 38 and 39. For this purpose the voltage divider is connected to a reference voltage source 53 while the base is connected to a capacitor 40 in order to ensure a stable potential on this base. The collector lead of transistor 31 contains a collector resistor 46 and in series with the latter a protective diode 49 which is connected in the cut-off direction to the reference voltage 53. The base of the input transistor 30 is also at a fixed potential via a voltage divider formed by the resistors 35 and 36. The modulation signal is fed to the base of transistor 30 via resistor 37.

If the modulation signal on line 67 is higher than the voltage on the base of transistor 31, transistor 30 will conduct and transistor 31 will be cut off. The current through transistor 30 is determined by the current source 32.

The base current flowing through the laser diode 51 via resistor 45 will have a value which is determined by the reference voltage 53 and resistor 45.

If the modulation voltage on the base of transistor 30 falls below the base voltage of transistor 31, transistor 30 will be cut off and transistor 31 will conduct. The energizing current which will now flow through the laser diode 51 is also determined by the current source 32 since the value of resistor 45 is much larger than the value of the collector resistor 46. Diodes 33 and 34 decouple the base-emitter capacitances of the transistors 30 and 31. This obviates current oscillations.

In order to obtain ideal switching characteristics for the laser switching amplifier 11, i.e., to ensure that the leading and trailing flanks of the generated current pulse through the laser diode are substantially identical for a symmetrical input pulse of 10 MHz over line 67, the circuit is made symmetrical. Diodes 47 and 48 and capacitor 44 create the same load for transistor 30 as the laser diode 51 does for transistor 31. Similarly, resistor 43 is equal to resistor 45 in order to give a load in the left-hand chain identical to the base current in the right-hand chain of the circuit in the "off" condition. It is also ensured that there is always a voltage drop across the load even when the current through the current source 32 is absent or at times when transistor 30 and transistor 31 operate in the switching zone. The symmetrical filter formed by resistors 42, 46 and capacitor 41 reduces the current over shoot to a negligible value.

At times when the laser diode 51 is "on", the photodiode 52 disposed in a housing 50 with the laser diode 51 will deliver a photo-current to the light intensity-to-voltage converter 12.

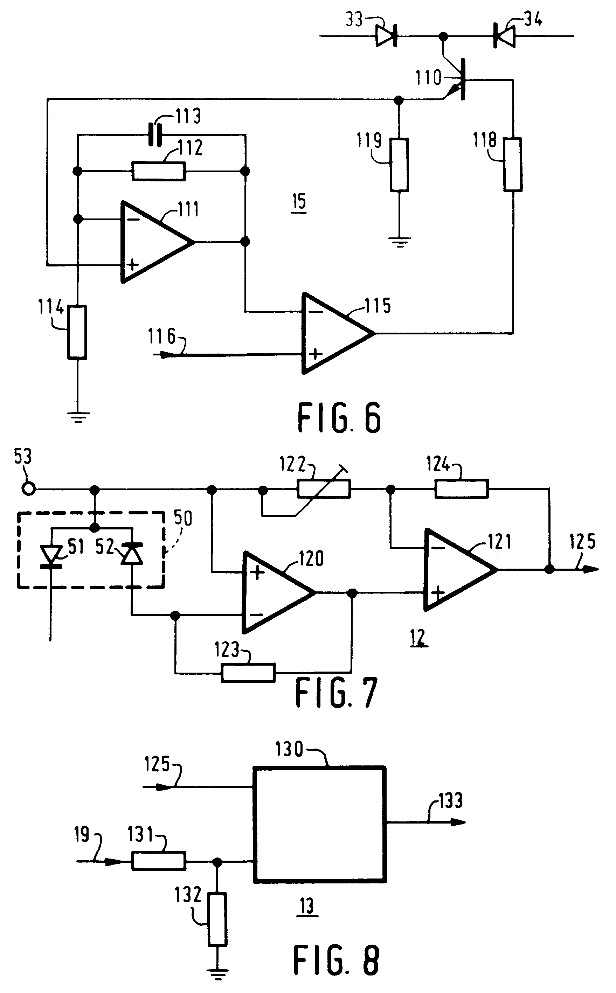

In this converter 12 (Fig. 7) the diode current is fed tot he inverting input of an amplifier 120 which together with resistor 123 converts this current into a voltage. On line 125 amplifier 121, the gain of which can be set by means of a potentiometer 122 and a resistor 124, gives an output signal whose value at maximum light output of laser diode 51 is equivalent to a predetermined voltage.

This output voltage on the line 125 is fed to the sample-and-hold circuit 130 (Fig.8). After each written line, a sampling pulse is fed to the sample-and-hold circuit 130 via a line 19 and a voltage divider formed by the resistors 131 and 132. The instantaneous value of the voltage on line 125 thus becomes available on line 133.

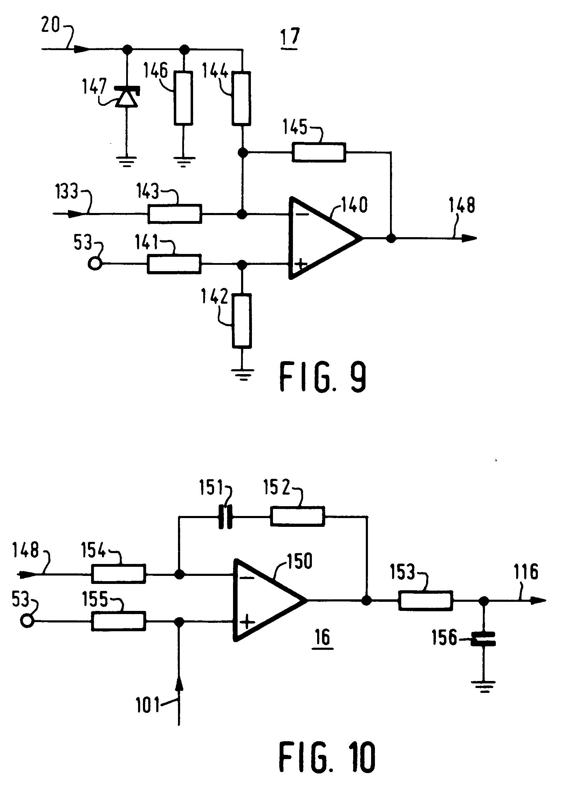

This voltage is fed (Fig. 9) to the inverting input of an amplifier 140 via a resistor 143. In addition, a reference voltage is fed to the inverting input of the amplifier 140 via line 20 and a voltage divider formed by resistors 146 and 144, the value of the reference voltage being related to the required current through the laser diode. The difference between the two voltages is amplified via amplifier 140 and resistor 145 and becomes available on line 148. Zener diode 147 prevents the output voltage on line 148 from being excessive, in the event of an excessive reference voltage on line 20, which whould result in the current through the laser diode exceeding a maximum value. The differential amplifier is set by a voltage divider formed by the resistors 141 and 142.

The differential voltage on line 148 (Fig. 10) is fed to the regulating amplifier 16. This regulating amplifier is constructed as an integrator around the operational amplifier 150, resistor 152 and capacitor 151. The speed of regulation of the integrator is determined by resistors 152 and 154, and capacitor 151. The integrated signal is flattened by a filter formed by resistor 153 and capacitor 156. The positive input of the operational amplifier 150 is connected to a reference voltage 53 via a resistor 155 and also to a protective circuit 14 via line 101.

The output signal of this regulating circuit is fed via line 116 to the voltage-to-current converter 15 (Fig. 6). This converter regulates the current through the laser diode in such manner as to give a constant light output. The variable current source is formed by transistor 110, resistor 119 and the two operational amplifiers 111 and 115. Capacitor 113 serves to stabilize the circuit. The range of regulation of the current source is such that even at the end of the life of the laser diode there is still sufficient current available to supply the maximum light output.

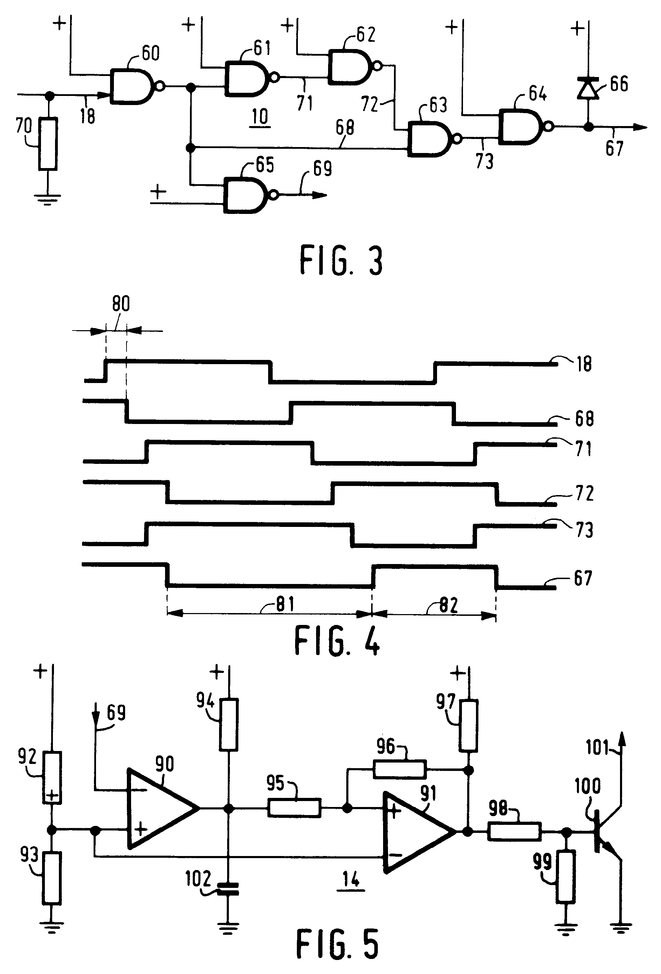

The image signal is fed via correction circuit 10 over line 69 to the protective circuit 14 (Fig. 5) and to the inverting input of the operational amplifier 90 constructed as a comparator circuit. The signal is compared with a d.c. voltage on the non-inverting input of the operational amplifier 90. This d.c. voltage is adjusted by means of resistors 92 and 93. If no image signal is supplied (laser continuously "off"), capacitor 102 will be slowly charged up via resistor 94. If this voltage, which is fed via resistor 95 to the non-inverting input of the second operational amplifier 91, is higher than the voltage on the invering input, the output of this second operational amplifier goes high and transistor 100 will conduct. Since the collector of transistor 100 is connected via line 101 to the non-inverting input of the operational amplifier 150 (Fig. 10), the voltage at this point will decrease and the current source will be switched off. This switching-off time occupies approximately two image line times.

If a current is fed to the laser diode, it still takes about 6nsec before the diode delivers light. When the current is switched off, the light output decreases to zero without delay. In order to correct for this anomaly, correction circuit 10 (Fig. 3) is added to the control circuit. A symmetrical image signal (see also Fig. 4) is fed to an NAND gate 60 via line 18. The output of this signal on line 68 is inverted and delayed for a time 80 with respect to the original image signal. This time 80 is approximately 3 nsec. This signal is fed via 2 NAND gates 61 and 62 and via line 72 to an input of NAND gate 63. The signals on lines 71 and 72 are thus always delayed for a time 80 with respect to the original signal. The signal on line 68 is fed to the other input of NAND gate 63. The leading flank of the resulting signal on line 73 is twice delayed for a time 80 and the trailing flank is delayed for a time 80 four times with respect to the original image signal. Since a "low" signal is required for the laser diode to emit light, the signal on line 73 is inverted again by means of NAND gate 64 and the resulting corrected image signal or modulation signal becomes available on line 67.

The time corresponding to 81 (Fig. 4) is lengthened by 2 x 3 nsec = 6 nsec, with respect to the original image signal, and as from the switching-off time the current through the laser diode is switched on 6 nsec earlier, so that the light delivery starts at exactly the right time (6 nsec later). The "off" time 82 is correspondingly shortened by 6 nsec.

For the correction described it is important that the leading and trailing flanks of the image signal supplied should be symmetrical with respect to one another. This can be achieved by gating the image signal with the laser printer clock signal. In this way image pulse distortion caused by supply lines with stray capacities is completely eliminated.

These and all the variations which can be derived there from by the skilled man in respect of the control circuit for a laser printer will, however, come under the following claims.

## Claims

1. A control circuit for a laser printer comprising a laser switchting amplifier (11) for supplying current to a laser diode (51), the laser switching amplifier (11) comprising a differential amplifier with a commom current source (32) and being made up of two chains, a first chain (31,46,45,51) comprising a first switching element (31) for switching a current of the current source through a laser diode (51) and a second chain (30,42,43,44,47,48) comprising a second switching element (30), characterised in that correction elements (44,47, 48) are disposed in the second chain (30,42,43,44,47,48) and represent in the second chain a dynamic load for the second switching element (30) which is identical or substantially identical to the load that the laser diode (51) represents for the first switching element (31) in the first chain.

2. A control circuit according to claim 1, characterised in that the correction elements (44,47,48) are formed by two diodes (47 and 48) connected in series to the second switching element (30) and a capacitor (44) which is earthed at one connecting point while the other connecting point is connected to the junction of the electrical connection between the second switching element (30) and the diodes (47,48).

## Patentansprüche

1. Steuerschaltung für einen Laserdrucker mit einem Laser-Schaltverstärker (11) zur Zufuhr von Strom zu einer Laserdiode (51), welcher Laser-Schaltverstärker (11) einen Differenzverstärker mit einer gemeinsamen Stromsquelle (32) aufweist und aus zwei Zweigen aufgebaut ist, einem ersten Zweig (31, 46, 45, 51) mit einem ersten Schaltelement (31) zum Einschalten eines Stromes der Stromquelle durch eine Laserdiode (51) und einem zweiten Zweig (30, 42, 43, 44, 47, 48) mit einem zweiten Schaltelement (30). dadurch gekennzeichnet, daß Korrekturelemente (44, 47, 48) in dem zweiten Zweig (30. 42, 43, 44, 47. 48) angeordnet sind und in dem zweiten Zweig eine dynamische Last für das zweite Schaltelement (30) bilden, die identisch oder im wesentlichen identisch mit der Last ist, die die Laserdiode (51) für das erste Schaltelement (31) in dem ersten Zweig bildet.

2. Steuerschaltung nach Anspruch 1, dadurch gekennzeichnet, daß die Korrekturelemente (44, 47, 48) durch zwei Dioden (47 und 48), die in Serie mit dem zweiten Schaltelement (30) geschaltet sind, und einen Kondensator (44) gebildet werden, der an einem Anschlußpunkt geerdet ist, während der andere Anschlußpunkt mit dem Verbindungspunkt zwischen dem zweiten Schaltelement (30) und den Dioden (47, 48) verbunden ist.

## Revendications

1. Circuit de commande pour une imprimante à laser comprenant un amplificateur (11) de commutation laser pour appliquer un courant à une diode laser (51), l'amplificateur (11) de commutation laser comprenant un amplificateur différentiel avec une source de courant commune (32) et étant constitué de deux chaînes, une première chaîne (31, 46, 45, 51) comprenant un premier élément de commutation (31) pour commuter un courant de la source de courant par l'intermédiaire d'une diode laser (51) et une seconde chaîne (30, 42, 43, 44, 47, 48) comprenant un second élément de commutation (30), caractérisé en ce que des éléments de correction (44, 47, 48) sont disposés dans la seconde chaîne (30, 42, 43, 44, 47, 48) et représentent dans la seconde chaîne une charge dynamique pour le second élément de commutation (30) qui est identique ou sensiblement identique à la charge que la diode laser (51) représente pour le premier élément de commutation (31) dans la première chaîne.

2. Circuit de commande selon la revendication 1, caractérisé en ce que les éléments de correction (44, 47, 48) sont formés par deux diodes (47 et 48) connectées en série au second élément de commutation (30) et un condensateur (44) qui est mis à la terre en un point de connexion tandis que l'autre point de connexion est connecté à la jonction de la connexion électrique entre le second élément de commutation (30) et les diodes (47, 48).
